# EUROPÄISCHE PATENTSCHRIFT

(11) **EP 3 137 657 B1**
(45) Veröffentlichungstag und Bekanntmachung des Hinweises auf die Patenterteilung: **02.02.2022**
(21) Anmeldenummer: 14781230.9
(22) Anmeldetag: 08.10.2014
(51) Int. Cl.: C30B 33/06, B28D 1/22, H01L 21/762, H01L 21/304, H01L 21/02, B23K 26/53

(54) **KOMBINIERTES FESTKÖRPERHERSTELLUNGSVERFAHREN MIT LASERBEHANDLUNG UND TEMPERATURINDUZIERTEN SPANNUNGEN ZUR ERZEUGUNG DREIDIMENSIONALER FESTKÖRPER**
COMBINED METHOD FOR PRODUCING SOLIDS, INVOLVING LASER TREATMENT AND TEMPERATURE-INDUCED STRESSES TO GENERATE THREE-DIMENSIONAL SOLIDS
PROCÉDÉ COMBINÉ DE FABRICATION DE CORPS SOLIDES PAR TRAITEMENT AU LASER ET TENSIONS THERMO-INDUITES POUR LA PRODUCTION DE CORPS SOLIDES TRIDIMENSIONNELS

(30) Priorität: 30.04.2014 DE 102014006328
(43) Veröffentlichungstag der Anmeldung: 08.03.2017
(73) Patentinhaber: Siltectra GmbH, 01099 Dresden (DE)
(72) Erfinder: RICHTER, Jan, 01277 Dresden (DE)
(74) Vertreter: Westphal, Mussgnug & Partner, Patentanwälte mbB
(86) Internationale Anmeldenummer: PCT/EP2014/071511
(87) Internationale Veröffentlichungsnummer: WO 2015/165552

(56) Entgegenhaltungen:
- WO-A2-2010/072675
- WO-A2-2013/126927
- JP-A- 2006 140 356
- JP-A- 2012 091 233
- US-A1- 2014 027 951
- US-A1- 2014 053 382

## Beschreibung

Die vorliegende Erfindung bezieht sich auf ein Verfahren zum Herstellen von Festkörpern gemäß dem Gegenstand von Anspruch 1.

In vielen technischen Bereichen (z.B. Mikroelektronik- oder Photovoltaiktechnologie) werden Materialien, wie z.B. Silizium, Germanium oder Saphir, häufig in der Form dünner Scheiben und Platten (so genannte Wafer) gebraucht. Standardmäßig werden solche Wafer derzeit durch Sägen aus einem Ingot hergestellt, wobei relativ große Materialverluste ("kerf-loss") entstehen. Da das verwendete Ausgangsmaterial oft sehr teuer ist, gibt es starke Bestrebungen, solche Wafers mit weniger Materialaufwand und damit effizienter und kostengünstiger herzustellen.

Beispielsweise gehen mit den derzeit üblichen Verfahren allein bei der Herstellung von Siliziumwafern für Solarzellen fast 50% des eingesetzten Materials als "kerf-loss" verloren. Weltweit gesehen entspricht dies einem jährlichen Verlust von über 2 Milliarden Euro. Da die Kosten des Wafers den größten Anteil an den Kosten der fertigen Solarzelle ausmachen (über 40%), könnten durch entsprechende Verbesserungen der Waferherstellung die Kosten von Solarzellen signifikant reduziert werden.

Besonders attraktiv für eine solche Waferherstellung ohne kerf-loss ("kerf-free wafering") erscheinen Verfahren, die auf das herkömmliche Sägen verzichten und z.B. durch Einsatz von temperaturinduzierten Spannungen direkt dünne Wafer von einem dickeren Werkstück abspalten können. Dazu gehören insbesondere Verfahren, wie sie z.B. in PCT/US2008/012140 und PCT/EP2009/067539 beschrieben sind, wo zum Erzeugen dieser Spannungen eine auf das Werkstück aufgetragene Polymerschicht verwendet wird.

Die Polymerschicht weist bei den erwähnten Verfahren einen im Vergleich zum Werkstück um ungefähr zwei Größenordnungen höheren thermischen Ausdehnungskoeffizienten auf. Außerdem kann durch Ausnutzen eines Glasübergangs ein relativ hoher Elastizitätsmodul in der Polymerschicht erreicht werden, so dass im Schichtsystem Polymerschicht-Werkstück durch Abkühlen genügend große Spannungen induziert werden können, um die Abspaltung von Wafer vom Werkstück zu ermöglichen.

Beim Abspalten eines Wafers vom Werkstück haftet bei den erwähnten Verfahren jeweils auf einer Seite des Wafers noch Polymer an. Der Wafer krümmt sich dabei sehr stark in Richtung dieser Polymerschicht, was ein kontrolliertes Abspalten erschwert, und z.B. zu Dickenschwankungen des abgespaltenen Wafers führen kann. Außerdem erschwert die starke Krümmung die weitere Verarbeitung und kann sogar zum Zerbrechen des Wafers führen.

Bei Verwendung der Verfahren nach bisherigem Stand der Technik weisen die hergestellten Wafer üblicherweise jeweils größere Dickenschwankungen auf, wobei die räumliche Dickenverteilung häufig ein Muster mit vierzähliger Symmetrie zeigt. Die totale Dickenschwankung über den ganzen Wafer gesehen ("total thickness variation", TTV) beträgt bei Verwendung der bisherigen Verfahren häufig mehr als 100% der mittleren Waferdicke (ein Wafer von bspw. 100 Mikrometer mittlerer Dicke, der z.B. an seiner dünnsten Stelle 50 Mikrometer dick und an seiner dicksten Stelle 170 Mikrometer dick ist, hat ein TTV von 170-50=120 Mikrometer, was relativ zu seiner mittleren Dicke einer totalen Dickenschwankung von 120% entspricht). Wafer mit solch starken Dickenschwankungen sind für viele Anwendungen nicht geeignet. Außerdem liegen bei den am häufigsten auftretenden vierzähligen Dickenverteilungsmustern die Bereiche mit den größten Schwankungen unglücklicherweise in der Mitte des Wafers, wo sie am meisten stören.

Außerdem entstehen beim Verfahren nach aktuellem Stand der Technik während der Bruchpropagation beim Abspalten selbst unerwünschte Oszillationen in den beteiligten Schichtsystemen, die den Verlauf der Bruchfront ungünstig beeinflussen und insbesondere zu signifikanten Dickenschwankungen des abgespaltenen Wafers führen können.

Zudem ist es bei den bisherigen Verfahren schwierig, einen reproduzierbar guten Wärmekontakt über die ganze Fläche der Polymerschicht sicherzustellen. Lokal ungenügender Wärmekontakt kann aber aufgrund der geringen thermischen Leitfähigkeit der verwendeten Polymere zu ungewollten, signifikanten lokalen Temperaturabweichungen im Schichtsystem führen, was sich seinerseits negativ auf die Kontrollierbarkeit der erzeugten Spannungsfelder und damit die Qualität der hergestellten Wafer auswirkt.

Weiterhin ist aus der Druckschrift DE 196 40 594 A1 ein Verfahren zur Trennung von Halbleitermaterialien mittels licht-induzierter Grenzflächenzersetzung und damit hergestellter Vorrichtungen, wie strukturierte und freistehende Halbleiterschichten und Bauelemente, bekannt. Das Verfahren gemäß der DE 196 40 594 A1 beinhaltet die Beleuchtung von Grenzflächen zwischen Substrat und Halbleiterschicht oder zwischen Halbleiterschichten, wodurch die Lichtabsorption an der Grenzfläche oder in einer dafür vorgesehenen Absorptionsschicht zur Materialzersetzung führt. Die Auswahl der Grenzfläche oder Halbleiterschicht, welche zur Zersetzung gebracht wird, erfolgt durch die Wahl der Lichtwellenlänge und Lichtintensität, die Einstrahlrichtung oder den Einbau einer dünnen Opferschicht während der Materialherstellung. Dieses Verfahren hat den Nachteil, dass zur Zerstörung ganzer Schichten hohe Energiedosen verwendet werden müssen, wodurch der Energiebedarf und somit die Kosten des Verfahrens sehr hoch sind.

In den Druckschriften WO 2013/126927 A2 und US 2014/053382 A1 sind Verfahren zur Abtrennung von Festkörperschichten von einem Werkstück mittels Laserstrahlen offenbart.

Es ist somit die Aufgabe der vorliegenden Erfindung ein Verfahren zur Herstellung von Festkörperschichten und/oder Festkörpern bereitzustellen, das die kostengünstige Herstellung von unebenen Festkörperplatten oder Festkörpern mit einer gewünschten Dickenverteilung ermöglicht.

Die zuvor genannte Aufgabe wird erfindungsgemäß durch ein Verfahren zur Herstellung von mindestens einer Festkörperschicht und/oder mindestens einem dreidimensionalen Festkörper, insbesondere zur Verwendung als Wafer, Scheibe, Linse oder Spat, gelöst. Das erfindungsgemäße Verfahren umfasst dabei bevorzugt die folgenden Schritte:
Bereitstellen eines Werkstücks zum Ablösen mindestens einer Festkörperschicht und/oder mindestens eines Festkörpers, wobei das Werkstück einen ersten ebenen Flächenanteil und einen zweiten ebenen Flächenanteil aufweist, wobei der erste ebene Flächenanteil im Wesentlichen oder genau parallel zu dem zweiten ebenen Flächenanteil ausgerichtet ist, wobei das Werkstück zumindest eine exponierte Oberfläche aufweist, wobei die exponierte Oberfläche durch den zweiten ebenen Flächenanteil ausgebildet wird, Erzeugen von Defekten mittels Laserstrahlen eines Lasers innerhalb des Werkstücks, wobei die Laserstrahlen über den zweiten ebenen Flächenanteil in den Festkörper eindringen, wobei die Defekte mindestens eine Rissführungsschicht vorgeben, wobei die Rissführungsschicht zumindest eine dreidimensionale Kontur beschreibt, Anbringung oder Erzeugung einer Aufnahmeschicht an der exponierten Oberfläche des Werkstücks unter Bildung einer Kompositstruktur, Temperieren der Aufnahmeschicht zum Erzeugen von Spannungen innerhalb des Werkstücks, wobei die Spannungen eine Rissausbreitung innerhalb des Werkstücks bewirken, wobei durch die Rissausbreitung eine dreidimensionale Festkörperschicht oder ein dreidimensionaler Festkörper von dem Werkstück entlang der Rissführungsschicht abgetrennt wird, wobei eine Oberfläche der Festkörperschicht oder des Festkörpers der dreidimensionalen Kontur der Rissführungsschicht entspricht, wobei die Gestalt der Rissführungsschicht zumindest abschnittsweise die Kontur eines dreidimensional vorbestimmten Objektes, welches sich aus einem mathematisch bestimmbaren Formkörpers ergibt, insbesondere einer Linse oder eines Spats, aufweist.

Weitere bevorzugte Ausführungsformen sind nachfolgend genannt und/oder Gegenstand der Unteransprüche.

Die Anbringung oder Erzeugung der Aufnahmeschicht an der exponierten Oberfläche des Werkstücks erfolgt gemäß einer weiteren bevorzugten Ausführungsform der vorliegenden Erfindung vor der Erzeugung der Defekte, wobei die Aufnahmeschicht mindestens eine lokal variierende Eigenschaft aufweist, wobei die Defekte durch Laserstrahlen eines Lasers erzeugt werden, wobei die Laserstrahlen derart von der Aufnahmeschicht beeinflusst werden, dass die Defekte in Abhängigkeit der mindestens einen lokal variierenden Eigenschaft erzeugt werden. Gemäß dieser Ausführungsform werden die Laserstrahlen somit bevorzugt direkt durch die Aufnahmeschicht geführt. Bei geeigneter Wahl der Aufnahmeschicht, kann die Rissführungsschicht, die zumindest eine dreidimensionale Kontur beschreibt, so erzeugt werden, dass zuerst die Aufnahmeschicht, insbesondere in Folienform, in gewünschter Art und Weise in einer 3D-Form bzw. mi einer 3D-Strukturierung hergestellt wird (z.B. Spritzguss). Die Aufnahmeschicht besteht dabei bevorzugt aus einem Polymer, insbesondere einem Elastomer oder mehreren Elastomeren, welche bevorzugt optisch stabil sind, wie z.B. einige Vertreter der Silikone. Die auf den Festkörper aufgebrachte, insbesondere aufgeklebte, Aufnahmeschicht bewirkt bei der Defekterzeugung, d.h. bei der Laserbeaufschlagung, durch ihre 3D-Strukturierung bzw. 3D-Form, dass sich der optische Weg des Lasers in geeigneter Art und Weise so verändert, dass die gewünschten Defekte, durch welche die Rissführungsschicht ausgebildet wird, erzeugt werden. Die lokal variierenden Eigenschaft der Aufnahmeschicht ist dabei bevorzugt die Dicke der Aufnahmeschicht.

Vor der Erzeugung der Defekte wird bevorzugt eine Immersionsflüssigkeit auf die exponierte Oberfläche aufgebracht und zur Erzeugung der Defekte erfolgt eine Beaufschlagung des Werkstücks durch die Immersionsflüssigkeit hindurch. Der Brechungsindex der Immersionsflüssigkeit stimmt bevorzugt mit dem Brechungsindex des Werkstücks zumindest im Wesentlichen überein. Diese Lösung ist vorteilhaft, da durch die Verwendung einer Immersionsflüssigkeit, insbesondere eines Öls oder Wasser, die beim Absplitten oder einer sonstigen Oberflächenbehandlung entstehende Rauigkeit der Oberfläche des Werkstücks ausgeglichen wird. Es ist durch die Verwendung der Immersionsflüssigkeit somit möglich, insbesondere ohne ein vor der Defekterzeugung und nach einem ersten Abspalten einer Festkörperschicht in der Regel übliches Polieren der exponierten Oberfläche, Defekte in dem Werkstück sehr genau einzubringen.

Die Immersionsflüssigkeit wird bevorzugt in einer solchen Menge auf der exponierten Oberfläche aufgebracht, dass durch sie zumindest mehr als die Hälfte und bevorzugt vollständig die exponierte Oberfläche benetzt wird

Die Immersionsflüssigkeit wird bevorzugt mit einer Abdeckplatte derart abgedeckt, dass zwischen der zu erzeugenden Rissführungsschicht und der Abdeckplatte derselbe Brechungsindex vorliegt, insbesondere keine Lufteinschlüsse zwischen der exponierten Oberfläche und der Abdeckplatte auftreten.

Die Abdeckplatte weist bevorzugt zumindest auf der von der exponierten Oberfläche des Werkstücks abgewandten Seite eine Oberflächenrauheit auf, die geringer ist als die Oberflächenrauheit der exponierten Oberfläche.

Die Immersionsflüssigkeit wird bevorzugt als Tropfen auf die exponierte Oberfläche aufgebracht und der Tropfen wird derart mit der Defekterzeugungsvorrichtung in Kontakt gebracht , dass eine Relativbewegung zwischen dem Werkstück und der Defekterzeugungsvorrichtung eine Umpositionierung des Tropfens bewirkt.

Die Defekte werden bevorzugt in einer Rissführungsschicht erzeugt, wobei die Rissführungsschicht gegenüber der Längsachse des Werkstücks geneigt erzeugt wird und wobei die Rissführungsschicht und die Längsachse in einem Winkel zueinander ausgerichtet sind, der von 90° abweicht.

Die Defekte werden bevorzugt mittels einer Defekterzeugungsvorrichtung erzeugt, wobei die Defekterzeugungsvorrichtung derart konfiguriert ist, dass die Defekte mit einem konstanten Abstand zur Defekterzeugungsvorrichtung in dem Werkstück erzeugt werden, wobei das Werkstück und die Defekterzeugungsvorrichtung derart relativ zueinander geneigt werden, dass die von der Defekterzeugungsvorrichtung erzeugten Defekte in der Rissführungsschicht erzeugt werden, wobei die Defekterzeugungsvorrichtung und das Werkstück während der Defekterzeugung lediglich zweidimensional zueinander umpositioniert werden. Die Defekterzeugungsvorrichtung wird somit bevorzugt gegenüber dem Werkstück umpositioniert oder das Werkstück wird gegenüber der Defekterzeugungsvorrichtung umpositioniert oder die Defekterzeugungsvorrichtung und das Werkstück werden beide zueinander umpositioniert.

Dies ist vorteilhaft, da die Defekterzeugungseinrichtung zur Defekterzeugung lediglich *umpositioniert* werden muss und keine Modifikation der Defekterzeugungsvorrichtung bewirkt werden muss, insbesondere keine veränderte Defekteinbringtiefe bestimmt und eingestellt werden muss.

Die Defekte werden bevorzugt mittels einer Defekterzeugungsvorrichtung erzeugt, wobei die Defekterzeugungsvorrichtung derart konfiguriert ist, dass die Defekte mit einem sich zeitweise veränderndem Abstand zur Defekterzeugungsvorrichtung in dem Werkstück erzeugt werden, wobei in Abhängigkeit von dem Abstand der Defekterzeugungsvorrichtung zu dem zu erzeugenden Defekts zumindest zeitweise eine Modifikation der Defekterzeugungsvorrichtung bewirkt wird, insbesondere eine veränderte Defekteinbringtiefe bestimmt und eingestellt wird. Dies ist vorteilhaft, da bevorzugt keine Neigungsvorrichtung zum Neigen des Werkstücks vorgesehen werden muss.

Die Defekterzeugungsvorrichtung wird bevorzugt in einer sich rechtwinklig zur Langsachse des Werkstücks erstreckenden Umpositionierebene umpositioniert und die Modifikation der Defekterzeugungsvorrichtung erfolgt derart in Abhängigkeit von der Position der Defekterzeugungsvorrichtung gegenüber dem Werkstück, dass Defekte in Abhängigkeit von der Position der Defekterzeugungsvorrichtung unterschiedlich weit von der Defekterzeugungsvorrichtung beabstandet erzeugt werden.

Die Rissführungsschicht ist bevorzugt in einem Winkel zwischen 88° und 45° und bevorzugt zwischen 87° und 60° und besonders bevorzugt zwischen 86° und 80° gegenüber der Längsachse geneigt.

Dies ist vorteilhaft, da bei der Kristallzucht das Kristall (ein Ingot) nicht immer gleich genau in der gewünschten Richtung wächst, vielmehr hat die Kristallzucht Toleranzen im Gradbereich und einige Kristalle sind außerhalb der gewünschten Spezifikation. Durch die erfindungsgemäße Lösung lassen sich Rissführungsschichten bevorzugt erzeugen, wodurch trotz der bei der Kristallzucht auftretenden Probleme geeignete Festkörperschichten herstellbar sind, wodurch der Ausschuss signifikant verringert werden kann.

Vorzugsweise werden Defekte innerhalb des Werkstücks zum Ausbilden von mindestens einer ersten Rissführungsschicht und einer zweiten Rissführungsschicht erzeugt, wobei eine Vielzahl der die erste Rissführungsschicht bildenden Defekte korrespondierende Defekt in der zweiten Rissführungsschicht aufweisen, wobei jeweils ein Defekte der ersten Rissführungsschicht und der jeweils mit dem Defekt der ersten Rissführungsschicht korrespondierende Defekt der zweiten Rissführungsschicht aus derselben Richtung erzeugt werden, bevorzugt wird durch die Rissausbreitung eine Festkörperschicht von dem Werkstück entlang der ersten Rissführungsschicht und/oder der zweiten Rissführungsschicht abgetrennt wird. Diese Lösung ist vorteilhaft, da bei einer Beaufschlagung von zwei, drei, vier oder mehr ebenen gleichzeitig bzw. unmittelbar nacheinander Fehler z.B. bei Verwendung eines Lasers durch den Lasereintritt in die Oberfläche minimiert, da nur die Differenz der beiden Fokuswerte wichtig ist und die Oberfläche diese Differenz nicht beeinflusst. Damit können (insbesondere sehr dünne) Wafer mit sehr genauem TTV und deutlich minimierten bow und warp erzeugt werden. Die beiden Rissführungsschichten, die bevorzugt als Ebenen erzeugt werden, können so ausgebildet werden, dass beim Absplitten erst eine Rissführungsschicht (z.B. die zweite Rissführungsschicht) und dann die andere bzw. eine weitere Rissführungsschicht (z.B. die erste Rissführungsschicht) splittet.

Gemäß der vorliegenden Erfindung wird ein Laser als Defekterzeugungsvorrichtung zum Erzeugen der Defekte verwendet, wobei die miteinander korrespondierenden Defekte der ersten Rissführungsschicht und der zweiten Rissführungsschicht bevorzugt jeweils nacheinander erzeugt werden.

Die Defekterzeugungsvorrichtung und die Oberfläche des Werkstücks werden bevorzugt zum Erzeugen von mindestens zwei miteinander korrespondierenden Defekten relativ zueinander ausgerichtet. Nach dem Erzeugen von mindestens zwei miteinander korrespondierenden Defekten werden die Defekterzeugungsvorrichtung und die Oberfläche des Werkstücks bevorzugt derart neu relativ zueinander ausgerichtet, dass mindestens zwei weitere miteinander korrespondierende Defekte erzeugt werden.

Die Defekte der ersten Rissführungsschicht sind bevorzugt weiter von der Oberfläche des Werkstücks beabstandet als die jeweils korrespondierenden Defekte der zweiten Rissführungsschicht, wobei von zwei miteinander korrespondierenden Defekten zunächst der die erste Rissführungsschicht mit ausbildende Defekt und danach der die zweite Rissführungsschicht mit ausbildende Defekt erzeugt wird.

Die erste Rissführungsschicht und/oder die zweite Rissführungsschicht weisen bevorzugt die Gestalt einer Ebene auf oder weisen eine zumindest teilweise von einer ebenen Gestalt abweichende Gestalt, insbesondere teilweise die Gestalt eines Spats oder einer Linse, auf.

Der Festkörper bzw. das Werkstück weist bevorzugt ein Material oder eine Materialkombination aus einer der Hauptgruppen 3, 4 und 5 des Periodensystems der Elemente auf, wie z.B. Si, SiC, SiGe, Ge, GaAs, InP, GaN, Al2O3 (Saphir), AIN. Besonders bevorzugt weist der Festkörper eine Kombination aus in der dritten und fünften Gruppe des Periodensystems vorkommenden Elementen auf. Denkbare Materialien oder Materialkombinationen sind dabei z.B. Galliumarsenid, Silizium, Siliziumcarbid, etc. Weiterhin kann der Festkörper eine Keramik (z.B. Al2O3 - Alumiumoxid) aufweisen oder aus einer Keramik bestehen, bevorzugte Keramiken sind dabei z.B. Perovskitkeramiken (wie z.B. Pb-, O-, Ti/Zr-haltige Keramiken) im Allgemeinen und Blei-Magnesium-Niobate, Bariumtitanat, Lithiumtitanat, Yttrium-Aluminium-Granat, insbesondere Yttrium-Aluminium-Granat Kristalle für Festkörperlaseranwendungen, SAW-Keramiken (surface acoustic wave), wie z.B. Lithiumniobat, Galliumorthophosphat, Quartz, Calziumtitanat, etc. im Speziellen. Der Festkörper weist somit bevorzugt ein Halbleitermaterial oder ein Keramikmaterial auf bzw. besonders bevorzugt besteht der Festkörper aus mindestens einem Halbleitermaterial oder einem Keramikmaterial. Es ist weiterhin denkbar, dass der Festkörper ein transparentes Material aufweist oder teilweise aus einem transparenten Material, wie z.B. Saphir, besteht bzw. gefertigt ist. Weitere Materialien, die hierbei als Festkörpermaterial alleine oder in Kombination mit einem anderen Material in Frage kommen, sind z.B. "wide band gap"-Materialien, InAlSb, Hochtemperatursupraleiter, insbesondere seltene Erden Cuprate (z.B. YBa2Cu3O7). Es ist zusätzlich oder alternativ denkbar, dass der Festkörper eine Photomaske ist, wobei als Photomaskenmaterial im vorliegenden Fall bevorzugt jedes zum Anmeldetag bekannte Photomaskenmaterial und besonders bevorzugt Kombinationen daraus verwendet werden können.

Bevorzugt werden Defekte mittels eines Lasers als Defekterzeugungsvorrichtung in der inneren Struktur des Werkstücks zum Vorgeben einer Rissführungsschicht, entlang der die Festkörperschicht oder der Festkörper vom Werkstück abgetrennt wird, erzeugt, wobei die Defekte derart voneinander beabstandet erzeugt werden, dass eine bei der jeweiligen Defekterzeugung lokal erfolgende Erhitzung des Werkstück von weiteren bei der Erzeugung weiterer Defekte erfolgenden Erhitzungen des Werkstücks entkoppelt ist, wobei bevorzugt jede bei der jeweiligen Defekterzeugung lokal erfolgende Erhitzung des Werkstück von den weiteren bei der Erzeugung weiterer Defekte erfolgenden Erhitzungen des Werkstücks entkoppelt ist.

Dies ist vorteilhaft, da die einzelnen lokalen Erhitzungen ungehindert abkühlen können und nicht durch nebeneinander erzeugte Defekte eine zusätzlich Erhitzung eines Teils des Werkstücks bewirkt wird, wodurch die Erzeugung hoher lokaler Spannungen verhindert wird.

Weitere Vorteile, Ziele und Eigenschaften der vorliegenden Erfindung werden anhand nachfolgender Beschreibung anliegender Zeichnungen erläutert, in welchen beispielhaft die Waferherstellung dargestellt ist. Bauteile oder Elemente der Waferherstellung, welche in den Figuren wenigstens im Wesentlichen hinsichtlich ihrer Funktion übereinstimmen, können hierbei mit gleichen Bezugszeichen gekennzeichnet sein, wobei diese Bauteile oder Elemente nicht in allen Figuren beziffert oder erläutert sein müssen.

Einzelne oder alle Darstellungen der im Nachfolgenden beschriebenen Figuren sind bevorzugt als Konstruktionszeichnungen anzusehen.

Darin zeigt:
- Fig. 1a: einen schematischen Aufbau zum Erzeugen von Lokal-Spannungen in einem Festkörper;
- Fig. 1b: eine schematische Darstellung einer Schichtanordnung vor dem Abtrennen einer Festkörperschicht von einem Festkörper;
- Fig. 1c: eine schematische Darstellung einer Schichtanordnung nach dem Abtrennen einer Festkörperschicht von einem Festkörper;
- Fig. 2a: eine erste schematisch dargestellte Variante zur Erzeugung von Lokal-Spannungen mittels Strahlung, insbesondere Lichtwellen;
- Fig. 2b: eine zweite schematisch dargestellte Variante zur Erzeugung von Lokal-Spannungen mittels Strahlung, insbesondere mittels Lichtwellen;
- Fig. 3a: die Erzeugung einer dreidimensionalen Rissführungsschicht;
- Fig. 3b: die Erzeugung einer weiteren Rissführungsschicht zur Erzeugung eines dreidimensionalen Festkörpers;
- Fig.4a-4c: Beispiele verschiedener 3D-Konturen der Rissführungsschicht;
- Fig. 4d: ein Beispiel für einen erzeugten Festkörper; und
- Fig. 5: eine weitere Anordnung zur Erzeugung einer Rissführungsschicht mit einer 3D-Kontur.

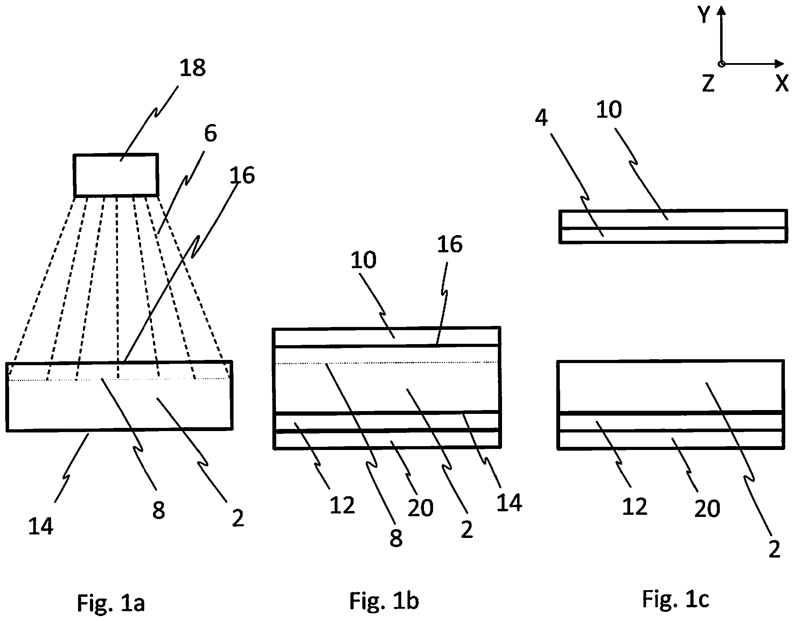

In Fig. 1a ist ein Werkstück 2 bzw. ein Substrat gezeigt, das im Bereich einer Strahlungsquelle 18, insbesondere einem Laser, angeordnet ist. Das Werkstück 2 weist bevorzugt einen ersten ebenen Flächenanteil 14 und einen zweiten ebenen Flächenanteil 16 auf, wobei der erste ebene Flächenanteil 14 bevorzugt im Wesentlichen oder genau parallel zu dem zweiten ebenen Flächenanteil 16 ausgerichtet ist. Der erste ebene Flächenanteil 14 und der zweite ebene Flächenanteil 16 begrenzen bevorzugt das Werkstück 2 in einer Y-Richtung, die bevorzugt vertikal bzw. lotrecht ausgerichtet ist. Die ebenen Flächenanteile 14 und 16 erstrecken sich bevorzugt jeweils in einer X-Z-Ebene, wobei die X-Z-Ebene bevorzugt horizontal ausgerichtet ist. Weiterhin lässt sich dieser Darstellung entnehmen, dass die Strahlungsquelle 18 Stahlen 6 zeitgleich oder zeitversetzt auf das Werkstück 2 ausstrahlt. Die Strahlen 6 dringen je nach Konfiguration definiert tief in das Werkstück 2 ein und erzeugen an der jeweiligen Position bzw. an einer vorbestimmten Position Lokal-Spannungen.

In Fig. 1b ist eine mehrschichtige Anordnung gezeigt, wobei das Werkstück 2 die Rissführungsschicht 8 beinhaltet und im Bereich des ersten ebenen Flächenanteils 14 mit einer Halteschicht 12 versehen ist, die wiederum bevorzugt von einer weiteren Schicht 20 überlagert wird, wobei die weitere Schicht 20 bevorzugt eine Stabilisierungseinrichtung, insbesondere eine Metallplatte, ist. An dem zweiten ebenen Flächenanteil 16 des Werkstücks 2 ist bevorzugt eine Polymerschicht 10 angeordnet. Die Aufnahmeschicht bzw. Polymerschicht 10 und/oder die Halteschicht 12 bestehen bevorzugt zumindest teilweise und besonders bevorzugt vollständig aus PDMS.

In Fig. 1c ist ein Zustand nach einer Rissauslösung und anschließender Rissführung gezeigt. Die Festkörperschicht 4 haftet an der Polymerschicht 10 und ist von dem verbleibenden Rest des Werkstücks 2 beabstandet bzw. beabstandbar.

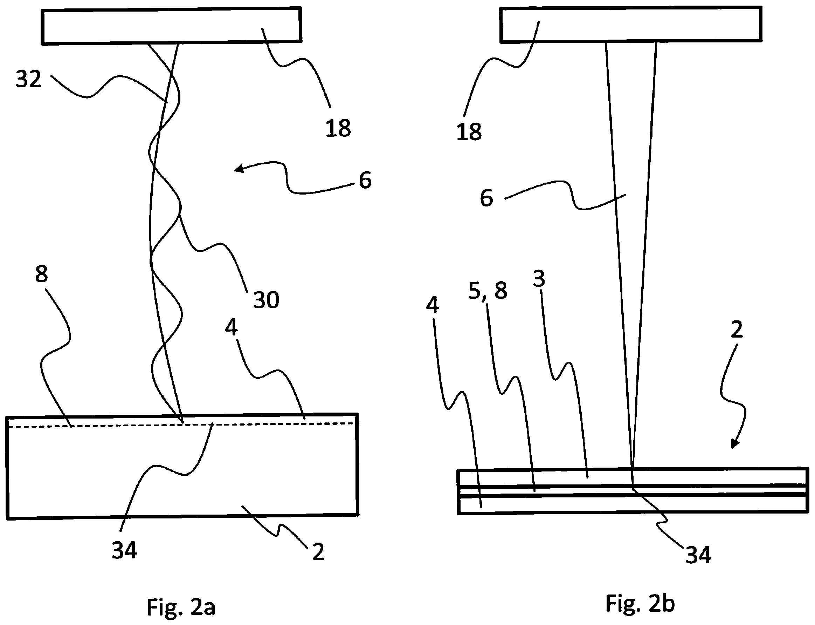

In den Figuren 2a und 2b sind Beispiele für die in Fig. 1a gezeigte Erzeugung einer Rissführungsschicht 8 durch die Einbringung von Lokal-Spannungen in ein Werkstück 2, insbesondere mittels Lichtstrahlen, gezeigt.

In Fig. 2a ist somit schematisch gezeigt, wie Lokal-Spannungen 34 in einem Werkstück 2, insbesondere zur Erzeugung einer Rissführungsschicht 8 mittels einer Strahlungsquelle 18, insbesondere einem oder mehrerer Laser, erzeugbar sind. Die Strahlungsquelle 18 emittiert dabei Strahlung 6 mit einer ersten Wellenlänge 30 und einer zweiten Wellenlänge 32. Die Wellenlängen 30, 32 sind dabei bevorzugt derart aufeinander abgestimmt bzw. die Distanz zwischen der Strahlungsquelle 18 und der zu erzeugenden Rissführungsschicht 8 ist bevorzugt derart abgestimmt, dass die Wellen 30, 32 im Wesentlichen oder genau auf der Rissführungsschicht 8 in dem Werkstück 2 zusammentreffen, wodurch am Ort des Zusammentreffens 34 infolge der Energien beider Wellen 30, 32 Lokal-Spannungen bzw. Defekte erzeugt werden. Die Erzeugung der Lokal-Spannungen kann dabei durch unterschiedliche oder kombinierte Mechanismen, wie z.B. Sublimation, Aufschmelzen und/oder chemische Reaktion, erfolgen.

In Fig. 2b ist ein fokussierter Lichtstrahl 6 gezeigt, dessen Brennpunkt bevorzugt in der Rissführungsschicht 8 liegt. Es ist hierbei denkbar, dass der Lichtstrahl 6 durch eine oder mehrere fokussierende Körper, insbesondere Linse/n (nichtgezeigt), fokussiert wird. Das Werkstück 2 ist in dieser Ausführungsform mehrschichtig ausgebildet und weist bevorzugt eine teiltransparente oder transparente Substratschicht 3 bzw. Materialschicht auf, die bevorzugt aus Saphir besteht oder Saphir aufweist. Die Lichtstrahlen 6 gelangen durch die Substratschicht 3 auf die Rissführungsschicht 8, die bevorzugt durch eine Opferschicht 5 gebildet wird, wobei die Opferschicht 5 durch die Strahlung derart beaufschlagt wird, dass die Erzeugung von Lokal-Spannungen in der Opferschicht 5 in dem Brennpunkt bzw. im Bereich des Brennpunkts bewirkt wird. Es ist ebenfalls denkbar, dass die Lokal-Spannungen zur Erzeugung der Rissführungsschicht 8 im Bereich oder genau auf einer Grenzfläche zwischen zwei Schichten 3, 4 erzeugt werden. Somit ist ebenfalls denkbar, dass die Festkörperschicht 4 auf einer Trägerschicht, insbesondere einer Substratschicht 3, erzeugt wird und mittels einer oder mehrerer Opferschichten 5 und/oder mittels der Erzeugung von Lokal-Spannungen in einer Grenzfläche, insbesondere zwischen der Festkörperschicht 4 und der Trägerschicht, eine Rissführungsschicht 8 zum Ablösen bzw. Abtrennen der Festkörperschicht 4 erzeugbar ist.

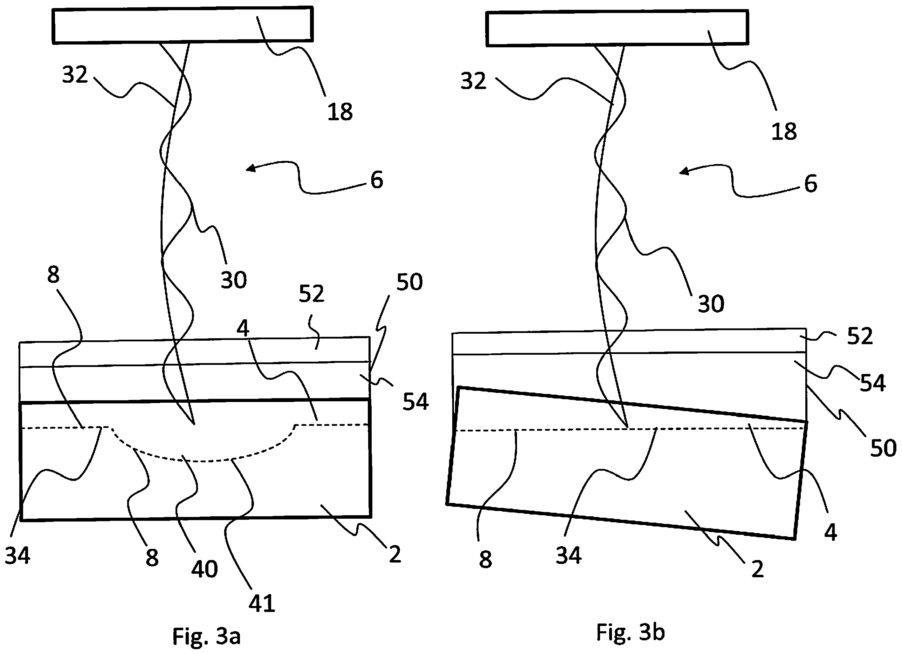

Gemäß Fig. 3a ist eine im Wesentlichen ähnliche Darstellung zu der in Fig. 2a gezeigten Darstellung gezeigt. Die Defekterzeugungseinrichtung 18 ist jedoch derart ausgeführt, dass sie die Defekte 34 zumindest abschnittsweise in voneinander verschiedenen Ebenen erzeugt, wodurch zumindest abschnittsweise die eine oder mehrere Rissführungsschichten 8 erzeugt werden, die der Oberfläche bzw. der Kontur der Oberfläche eines dreidimensionalen Körpers entsprechen.

Es kann somit nicht nur eine ebene Festkörperschicht 4, sondern ebenfalls ein unebener Festkörper 40 in Folge eines Bruchs oder einer Rissführung aus einem Werkstück 2 herausgelöst werden. Weiterhin ist denkbar, dass ein Festkörper 40 aus dem Werkstück 2 herausgelöst wird, der sich abschnittsweise eben und abschnittsweise dreidimensional erstreckt.

Ferner ist denkbar, dass eine Immersionsflüssigkeit 54 als Tropfen oder, wie dargestellt, als Flüssigkeitsschicht, auf der exponierten Oberfläche des Werkstücks 2 aufgebracht wird. Ist die Immersionsflüssigkeit 54 als Flüssigkeitsschicht vorgesehen, dann ist bevorzugt auch eine Wandungseinrichtung 50 zum Ausbilden einer Aufnahmewanne vorgesehen, damit die Flüssigkeit an der gewünschten Position gehalten wird. Weiterhin kann eine Abdeckplatte 52 auf die Flüssigkeit aufgebracht, insbesondere aufgelegt oder eingetaucht, werden. Die Immersionsflüssigkeit 54 weist bevorzugt im Wesentlichen oder genau denselben Brechungsindex auf, wie das Werkstück 2. Der Brechungsindex der Abdeckplatte kann von dem Brechungsindex der Immersionsflüssigkeit abweichen oder ebenfalls damit übereinstimmen. Es ist somit besonders bevorzugt denkbar, dass, insbesondere zum Ausgleich von Oberflächenrauheiten, die Defekterzeugung durch die Immersionsflüssigkeit 54 und besonders bevorzugt durch die Immersionsflüssigkeit 54 und die Abdeckplatte 52 hindurch erzeugt wird. Der Fokus des Lasers 18 wird zur Defekterzeugung bevorzugt computergesteuert geführt.

In Fig. 3b ist eine weitere Anordnung gezeigt, gemäß der in einem geneigten Werkstück 2, insbesondere einem Ingot, eine zum Ablösen einer unebene Festkörperschicht 4 bzw. eines unebenen Festkörpers 40 eine Rissführungsschicht 8 erzeugt wird. Zur präzisen Erzeugung der Rissführungsschicht 8 wird bevorzugt eine Immersionsflüssigkeit 54 bereitgestellt. Die als Tropfen oder, wie dargestellt, als Flüssigkeitsschicht auf der exponierten Oberfläche des Werkstücks 2 aufgebracht wird. Ist die Immersionsflüssigkeit 54 als Flüssigkeitsschicht vorgesehen, dann ist bevorzugt auch eine Wandungseinrichtung 50 zum Ausbilden einer Aufnahmewanne vorgesehen, damit die Flüssigkeit an der gewünschten Position gehalten wird. Weiterhin kann eine Abdeckplatte 52 auf die Flüssigkeit aufgebracht, insbesondere aufgelegt oder eingetaucht, werden. Die Immersionsflüssigkeit 54 weist bevorzugt im Wesentlichen oder genau denselben Brechungsindex auf, wie das Werkstück 2. Durch die Immersionsflüssigkeit 54 wird bewirkt, dass in dem Weg zwischen der Abdeckplatte 52 und der zu erzeugenden Rissführungsschicht 8 stets der gleiche Brechungsindex vorliegt, damit die Defekterzeugung möglichst fehlerfrei erfolgen kann.

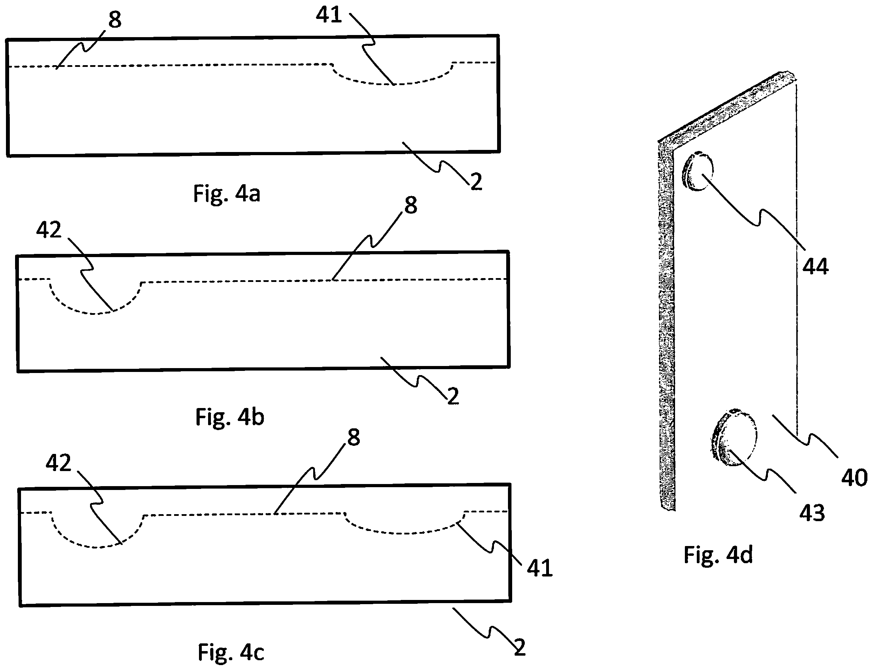

In der Fig. 4a ist ein Werkstück 2 gezeigt, das bevorzugt aus Saphir besteht oder Saphir aufweist und in dem eine Rissführungsschicht 8, ddurch eingebrachte bzw. erzeugte Defekte 34 ausgebildet wird. Die Rissführungsschicht 8 weist hierbei einen ebenen und einen gebogenen Konturenanteil auf. Der erste Konturenanteil 41 kann hierbei z.B. der Kontur einer Linse entsprechen. Es ist ferner denkbar, dass die Rissführungsschicht 8 keinen ebenen, sondern ausschließlich gebogene oder zueinander geneigte Konturenanteile aufweist.

In Fig. 4b ist die Rissführungsschicht 8 derart ausgebildet, dass die zweite 3D-Kontur schmaler und höher als die erste 3D-Kontur 41 ausgebildet ist. Es ist hierbei denkbar, dass eine 3D-Kontur, mehrere, insbesondere 2, 3, 4, 5, 6, 7 oder mehr als 7 3D-Konturen, eine Rissführungsschicht 8 ausbilden. Weiterhin ist denkbar, dass eine 3D-Kontur 41/42 im Zentrum oder außerhalb des Zentrums der Rissführungsschicht 8 erzeugt wird. Die 3D-Kontur 42 kann hierbei z.B. teilweise oder vollständig die Gestalt eines Sensors, insbesondere eines Touchsensors, oder eines Anteils eines Sensorgehäuses aufweisen.

In Fig. 4c ist eine Darstellung gezeigt, gemäß der die Rissführungsschicht 8 mehrere, insbesondere zwei, 3D-Konturen aufweist. Ein Beispiel, wie der sich daraus ergebende Festkörper 40 aussehen kann, ist in Fig. 4d gezeigt. Der Fig. 4d lässt sich ein einstückiger Festkörper entnehmen, der ebenen Anteile und mehrere, insbesondere zwei, gleiche oder voneinander verschiedene 3D-Körperanteile 43, 44 aufweist.

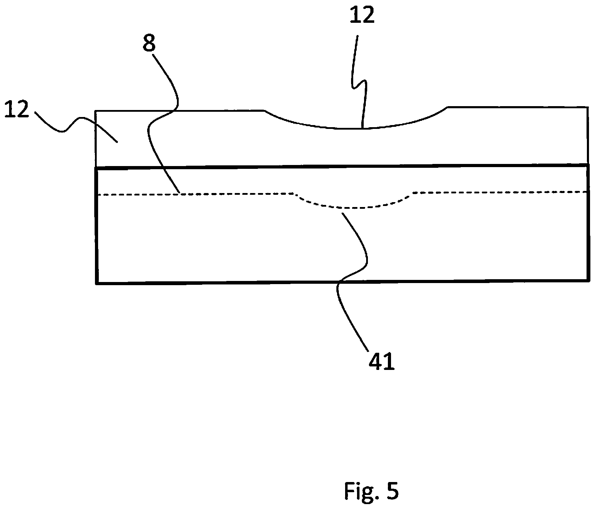

In Fig. 5 ist eine Darstellung gezeigt, gemäß der eine strukturierte Folie auf dem Werkstück 2 angeordnet ist. Es ist hierbei denkbar, dass die Folie vorstrukturiert ist oder, dass die Folie auf dem Werkstück strukturiert wird. Bevorzugt wird die Folie strukturiert gefertigt und auf das Werkstück 2 aufgeklebt. Die Struktur der Folie ist bevorzugt derart gewählt, dass die Laserstrahlen einer Defekterzeugungsvorrichtung 18 durch die Form der Folie derart abgelenkt werden, dass sie eine vorbestimmte 3D-Kontur einer Rissführungsschicht 8 erzeugen.

### Bezugszeichenliste

- 2: Werkstück
- 3: Substrat
- 4: Festkörperschicht
- 5: Opferschicht
- 6: Strahlung
- 8: Rissführungsschicht
- 10: Polymerschicht/Aufnahmeschicht
- 12: Halteschicht
- 14: erster ebener Flächenanteil
- 16: zweiter ebener Flächenanteil
- 18: Strahlungsquelle/Defekterzeugungsvorrichtung
- 20: Stabilisierungseinrichtung
- 30: erster Strahlungsanteil
- 32: zweiter Strahlungsanteil
- 34: Ort der Erzeugung von Lokal-Spannungen/Defekt
- 40: Festkörper
- 41: erste 3D-Kontur
- 42: zweite 3D-Kontur
- 43: erster 3D-Körper
- 44: zweiter 3D-Körper
- 50: Wandung
- 52: Abdeckplatte
- 54: Immersionsflüssigkeit

- X: erste Richtung
- Y: zweite Richtung
- Z: dritte Richtung

## Patentansprüche

1. Verfahren zur Herstellung mindestens einer dreidimensionalen Festkörperschicht (4), insbesondere zur Verwendung als Wafer, und/oder mindestens eines dreidimensionalen Festkörpers (40) mit den folgenden Schritten:
Bereitstellen eines Werkstücks (2) zum Ablösen der mindestens einen Festkörperschicht (4) und/oder des mindestens einen Festkörpers (40), wobei das Werkstück (2) einen ersten ebenen Flächenanteil (14) und einen zweiten ebenen Flächenanteil (16) aufweist, wobei der erste ebene Flächenanteil (14) im Wesentlichen oder genau parallel zu dem zweiten ebenen Flächenanteil (16) ausgerichtet ist, wobei das Werkstück (2) zumindest eine exponierte Oberfläche aufweist, wobei die exponierte Oberfläche durch den zweiten ebenen Flächenanteil ausgebildet wird,
Erzeugen von Defekten (34) mittels Laserstrahlen eines Lasers innerhalb des Werkstücks (2), wobei die Laserstrahlen über den zweiten ebenen Flächenanteil (16) in den Festkörper (2) eindringen, wobei die Defekte (34) mindestens eine Rissführungsschicht (8) vorgeben, wobei die Rissführungsschicht (8) zumindest eine dreidimensionale Kontur beschreibt,
Anbringung oder Erzeugung einer Aufnahmeschicht (10) an der exponierten Oberfläche des Werkstücks (2) unter Bildung einer Kompositstruktur,
Temperieren der Aufnahmeschicht zum Erzeugen von Spannungen innerhalb des Werkstücks (2), wobei die Spannungen eine Rissausbreitung innerhalb des Werkstücks (2) bewirken, wobei durch die Rissausbreitung eine dreidimensionale Festkörperschicht (4) oder ein dreidimensionaler Festkörper (40) von dem Werkstück (2) entlang der Rissführungsschicht (8) abgetrennt wird, wobei eine Oberfläche der Festkörperschicht (4) oder des Festkörpers der dreidimensionalen Kontur der Rissführungsschicht (8) entspricht, wobei die Gestalt der Rissführungsschicht (8) zumindest abschnittsweise die Kontur eines dreidimensional vorbestimmten Objektes, welches sich aus einem mathematisch bestimmbaren Formkörpers ergibt, insbesondere einer Linse oder eines Spats, aufweist.

2. Verfahren nach Anspruch 1,
**dadurch gekennzeichnet, dass**
die Anbringung oder Erzeugung der Aufnahmeschicht (10) an der exponierten Oberfläche des Werkstücks (2) vor der Erzeugung der Defekt erfolgt, wobei die Aufnahmeschicht mindestens eine lokal variierende Eigenschaft aufweist, wobei die Defekte durch Laserstrahlen eines Lasers erzeugt werden, wobei die Laserstrahlen derart von der Aufnahmeschicht beeinflusst werden, dass die Defekte in Abhängigkeit der mindestens einen lokal variierenden Eigenschaft erzeugt werden.

3. Verfahren nach Anspruch 2,
**dadurch gekennzeichnet, dass**
die lokal variierende Eigenschaft die Dicke der Aufnahmeschicht ist.

## Claims

1. Method for fabricating at least one three-dimensional solid-state layer (4), in particular for use as wafer, and/or at least one three-dimensional solid-state body (40) comprising the following steps:
providing a workpiece (2) for detaching the at least one solid-state layer (4) and/or the at least one solid-state body (40), wherein the workpiece (2) has a first planar surface portion (14) and a second planar surface portion (16), wherein the first planar surface portion (14) is aligned substantially or exactly parallel to the second planar surface portion (16), wherein the workpiece (2) has at least one exposed surface, wherein the exposed surface is formed by the second planar surface portion,
producing defects (34) by means of laser beams of a laser within the workpiece (2), wherein the laser beams penetrate into the solid-state body (2) via the second planar surface portion (16), wherein the defects (34) predefine at least one crack guiding layer (8), wherein the crack guiding layer (8) describes at least one three-dimensional contour,
attaching or producing a receiving layer (10) at the exposed surface of the workpiece (2) to form a composite structure,
regulating the temperature of the receiving layer in order to produce stresses within the workpiece (2), wherein the stresses cause crack propagation within the workpiece (2), wherein, as a result of the crack propagation, a three-dimensional solid-state layer (4) or a three-dimensional solid-state body (40) is separated from the workpiece (2) along the crack guiding layer (8), wherein a surface of the solid-state layer (4) or of the solid-state body corresponds to the three-dimensional contour of the crack guiding layer (8), wherein the shape of the crack guiding layer (8) has, at least in sections, the contour of a three-dimensionally predetermined object resulting from a mathematically determinable shaped body, in particular of a lens or of a parallelepiped.

2. Method according to Claim 1,
**characterized in that**
attaching or producing the receiving layer (10) at the exposed surface of the workpiece (2) is carried out before producing the defects, wherein the receiving layer has at least one locally varying property, wherein the defects are produced by laser beams of a laser, wherein the laser beams are influenced by the receiving layer in such a way that the defects are produced depending on the at least one locally varying property.

3. Method according to Claim 2,
**characterized in that**
the locally varying property is the thickness of the receiving layer.

## Revendications

1. Procédé de fabrication d'au moins une couche (4) de corps solide en trois dimensions, à utiliser notamment comme tranche, et/ou d'au moins un corps (40) solide en trois dimensions, comprenant les stades suivants :
on se procure une pièce (2) pour le détachement de la moins une couche (4) de corps solide et/ou du au moins un corps (40) solide, la pièce (2) ayant une première proportion (14) de surface plane et une deuxième proportion (16) de surface plane, dans lequel la première proportion (14) de surface plane est dirigée sensiblement ou exactement parallèlement à la deuxième proportion (16) de surface plane, dans lequel la pièce (2) a au moins une surface à découvert, dans lequel on constitue la surface à découvert par la deuxième proportion de surface plane,
on produit des défauts (34) au moyen de rayons d'un laser au sein de la pièce (2), dans lequel les rayons laser pénètrent dans le corps (2) solide par la deuxième proportion (16) de surface plane, dans lequel les défauts (34) prescrivent au moins une couche (8) de guidage de fissure, dans lequel la couche (8) de guidage de fissure décrit au moins un contour tridimensionnel,
on met ou on produit une couche (10) de réception sur la surface à découvert de la pièce (2) en formant une structure composite,
on met en température la couche de réception pour produire des tensions au sein de la pièce (2), les tensions provoquant une propagation de fissure au sein de la pièce (2), dans lequel par la propagation de fissure, on sépare une couche (4) de corps solide en trois dimensions ou un corps (40) solide en trois dimensions de la pièce (2) suivant la couche (8) de guidage de fissure, dans lequel une surface de la couche (4) du corps solide ou du corps solide correspond au contour en trois dimensions de la couche (8) de guidage de fissure, dans lequel la forme de la couche (8) de guidage de fissure a au moins par endroit le contour d'un objet en trois dimensions déterminé à l'avance, qui provient d'un corps de forme pouvant être déterminé mathématiquement, notamment d'une lentille ou d'un spath.

2. Procédé suivant la revendication 1,
**caractérisé en ce que**
on monte ou on produit la couche (10) de réception sur la surface à découvert de la pièce (2) avant la production du défaut, dans lequel la couche de réception a au moins une propriété variant localement, dans lequel on produit le défaut par des rayons d'un laser, dans lequel on influence les rayons du laser par la couche de réception de manière à produire les défauts en fonction de la au moins une propriété variant localement.

3. Procédé suivant la revendication 2,
**caractérisé en ce que**
la propriété variant localement est l'épaisseur de la couche de réception.
